# EUROPEAN PATENT APPLICATION

(11) **EP 4 764 026 A1**
(43) Date of publication of application: **24.06.2026**
(21) Application number: 24853084.2
(22) Date of filing: 13.08.2024
(51) Int. Cl.: C23C 14/14, C23C 14/16, C23C 14/18, C23C 14/20, C23C 14/24, C23C 14/54, C23C 14/02

(54) **METHOD OF MANUFACTURING POWDERED MATERIALS BY CONTROLLED SPRAYING OF ATOMS OF A TARGET MATERIAL AND SUBSEQUENT DEPOSITION ON A POWDERED BASE MATERIAL**

(30) Priority: 17.08.2023 BR 102023016544
(71) Applicant: Co2In Participações Ltda., Florianópolis, SC 88032-005 (BR)
(72) Inventor: FRIEDRICH FEIL, Adriano, 90830-244 Porto Alegre/RS (BR); EBERHARDT, Dario, 94931-023 CACHOEIRINHA/RS (BR)
(74) Representative: Neves, Ana
(86) International application number: PCT/BR2024/050358
(87) International publication number: WO 2025/035198

(57) **Abstract**

The present invention discloses a process for manufacturing new powder materials by controlled atom ejection. In this process, the material to be deposited (target material) may be selected from any element of the periodic table or from a combination of at least two such elements. The material receiving the deposition, referred to as the base material or substrate, may be selected from polymeric, metallic, semiconductor, ceramic, molecular sieve, perovskite, MOF, carbonaceous materials, or any type or class of powder material having a vapor pressure lower than 10⁻¹ mbar. The process taught by the present invention describes means for planning and achieving different coating structures on the base material (substrate) through the definition and control of production parameters. As a result, a plurality of new materials with new properties, as well as predefined properties, can be obtained.

## Description

### FIELD OF THE INVENTION

The present invention relates to the field of materials engineering. More specifically, it refers to a standardized and precise process for manufacturing powder materials, in which the structure of the deposited layer can be planned and is accurately achieved through the definition and control of production parameters. The present invention enables the planning and execution of a plurality of novel structures and novel materials.

### BACKGROUND OF THE INVENTION

Climate change is one of the factors motivating researchers to develop new technologies that are cleaner, that is, technologies that require less energy in their production, emit fewer pollutants, or require smaller amounts of raw materials for manufacturing. To this end, the study of new materials has gained increasing importance..

The methodology of coating base materials (substrates) with other materials (targets) in order to impart new properties is well established and has provided numerous alternatives for various industrial sectors, such as the automotive industry, aviation, structural applications, jewelry, catalytic processes, among others.

New materials are commonly developed through the appropriate combination of elements found in nature. Such combinations may occur through chemical or physical means. In general, chemical means present certain disadvantages, such as increased waste generation, lower stability, and greater difficulty in process control. Among physical means, the technologies are also known, and examples include atom ejection by momentum transfer (sputtering), ejection by sublimation through heat (thermal deposition), ejection by sublimation via electron beam (e-beam deposition), and laser-based ejection (laser ablation). These processes are collectively known as physical vapor deposition (PVD).

Traditionally, PVD processes are used in various industrial sectors such as microelectronics, data storage, medical equipment and devices, energy, metal-mechanical industries (particularly for solid parts requiring advanced properties), and decorative coatings such as glass façades between buildings, jewelry, and the like. It is important to note that, in traditional industry, these processes are commonly applied to solid and planar components of various shapes and sizes.

However, traditional surface coating processes present limitations with respect to the development of new materials, mainly due to their restricted application to already massive and solid parts. Furthermore, they require large concentrations of target elements to be adhered to the surface of the base material (substrate) and do not provide precise control over the formation of the different possible structures on the surfaces of base materials (planar substrates).

A search of the prior art in national and international databases identified certain documents addressing processes for depositing particulate materials by means of physical vapor deposition (PVD).

Patent application BRPI0823165A2 relates to particulate ceramic materials coated with a layer of nanoparticles having multiple crystalline structures, as well as to a process for obtaining such materials. These coatings are obtained by introducing precursors into a water-in-oil emulsion which, upon decomposition during detonation, form nanoparticles that adhere to the surface of the ceramic powder. The characteristics of the resulting coating, such as thickness, adhesion, porosity, and percentage of surface coverage, may be adjusted according to the control of process variables. The thickness of the coating layer ranges from 5 to 150 nm. The ceramic powders may be coated with multiple crystalline structures, including binary, ternary, or higher-order structures. However, although the document describes a process in which specific manufacturing characteristics, such as the layer structure, are defined through control of production processes, this objective is achieved by means of a water-in-oil emulsion detonation process, which differs from the present invention, wherein the applied process is physical vapor deposition (PVD).

Document WO2016175552A1 describes a method for preparing a conductive composite resin, which includes a step of forming inorganic nanoparticles on the surface of a carbon-based substrate having a particle size between 0.01 and 100 micrometers, by means of PVD. The document describes a powder base material (substrate) and a target comprising nanometric particles to be adhered to the surface of the base material through PVD. The powder base material is subjected to agitation at a rate between 0.1 and 400 rpm. The vaporized particles are deposited onto the base powder at a thickness of 1 to 10 micrometers per unit area per minute, such that control of the parameters is capable of providing different structures in the deposited layer. However, the process described therein does not teach or demonstrate means for controlling the final structure to be formed with precise control over dispersion, concentration, and dimensional scale of the final structure.

Document WO0028969A2 describes a physical vapor deposition (PVD) process applied to pharmaceutical particles. The number of coating particles and the structure of the coating layer vary according to the intended objective and are achieved through control of physical deposition parameters, such as vapor pressure and exposure time of the target particles. The document also teaches that the material to be coated may be of organic or inorganic origin and that the coating thickness may range from 1 nm to 1000 nm or more. Nevertheless, this document does not disclose a process for obtaining new materials having single-atom, cluster, or sub-nanometric structures, nor does it disclose precise control over the dispersion of atoms on the surface of the substrate.

Document US2013011440A1 describes a method for depositing thin layers, particularly for the production of multilayer coatings, comprising nanolayers, nanostructures, and nanocomposites. The deposition process is demonstrated through the following steps:
a) selecting a substrate material;
b) selecting a target material, which comprises at least two materials having distinct physicochemical properties;
c) providing a laser beam having non-uniform intensity and width;
d) directing the laser onto the target, wherein at least two segments of the target are exposed to different laser intensities; and
e) coordinating the parameters such that each target material absorbs an appropriate amount of energy to enable evaporation or desorption of the material.

The target materials may be organic or inorganic. The parameters to be controlled include wavelength, laser beam pulse duration, pulse repetition rate, distance between the target material and the substrate, and orientation of the substrate relative to the target. In addition to not disclosing a process that teaches the formation of single-atom, cluster, or sub-nanometric structures, the process required by this document does not include powder substrates, which differs from the present invention.

Document KR102478642B1 teaches a process for producing niacinamide powder containing gold particles and, more specifically, teaches a method for producing niacinamide powder containing gold particles capable of maintaining a colloidal state in a solvent by uniformly distributing gold nanoparticles. However, such document does not disclose a controlled deposition process according to a desired structure, which distinguishes it from the present invention.

Accordingly, the object of the present patent is to overcome the limitations related to the development of new materials by providing control and precision in the formation of different structures on the surface of the substrate.

### SUMMARY OF THE INVENTION

The object of the present invention is a standardized and precise process for manufacturing powder materials by means of controlled atom spraying of a target material and subsequent deposition thereof onto a powder base material (substrate), comprising the steps of:
a) selecting a powder substrate material having a vapor pressure lower than 100 mbar;
b) optionally performing a degassing step of the substrate material;
c) introducing the substrate material into a main vacuum chamber;
d) evacuating the chamber to the lowest possible pressure, preferably a maximum of 5 × 10⁻⁶ mbar;
e) selecting at least one element from the periodic table or combinations thereof, which is solid and has a vapor pressure lower than 10⁰ mbar, as the target material;
f) defining the type of coating structure to be formed on the surface of the substrate material, which may be single atom, cluster, sub-nanoparticle, or nanoparticle;
g) defining the values of the parameters comprising power density and deposition rate;
h) introducing the target materials into the equipment cathodes;
i) introducing a controlled flow of at least one gas into the vacuum chamber, between 0.1 sccm and 10 sccm;
j) maintaining the working pressure between 5 × 10⁻³ mbar and 5 × 10⁻¹ mbar;
k) activating the power supply and stabilizing the plasma at a power density between 0.1 W/cm² and 25 W/cm²;
l) initiating the deposition process of atoms of the target material onto the surface of the substrate material;
m) maintaining the process for a period from 0.3 min/g to 500 min/g to allow deposition of the atoms of the target material onto the surface of the substrate material;
n) maintaining the atomic concentration not greater than 10 at%;
o) switching off the power supply; and
p) packaging the coated substrate material.

An object of the present invention is that the selected substrate may be any powder material having a vapor pressure lower than 1001 mbar, preferably polymeric, metallic, semiconductor, ceramic materials, molecular sieves, perovskites, MOFs (metal-organic frameworks), and carbon-based materials.

It is also an object of the present invention that the target material preferably exhibits a vapor pressure of 100 mbar.

It is a further object of the present invention to perform degassing when the substrate material presents moisture.

Another object of the present invention is that the degassing of the substrate material comprises the steps of:
a) introducing the substrate material into a pre-vacuum chamber;
b) evacuating the chamber until reaching a pressure of 2 × 10⁻² mbar;
c) maintaining the substrate material in the pre-vacuum chamber for a period between 1 h and 8 h.

It is also an object of the present invention that the optional degassing step of the substrate material preferably occurs for 3 h.

It is a further object of the present invention that defining the operating parameter data, comprising power density and deposition rate, includes the steps of:
a) Establishing an initial power density of the equipment, which may range from 0.1 to 25 W/cm²;
b) calibrating the deposition rate of the target material;
c) verifying whether the deposition rate of the target material is suitable to achieve the atomic concentration of the planned structure; if not,
d) adjusting the power density until the deposition rate is sufficient to achieve the referenced atomic concentration for each structure.

Another object of the present invention comprises the alternative of performing a thermal treatment on the deposited material at the end of the process.

It is also an object of the invention that the gas flow control is carried out by means of a mass flow controller system.

It is an object of the present invention that, for the single-atom structure, the process parameters comprise:
- vacuum pressure between 5 × 10⁻⁵ mbar and 5 × 10⁻⁶ mbar, preferably 5 × 10⁻⁶ mbar;
- plasma power density between 0.1 and 25 W/cm², preferably between 0.32 and 1.93 W/cm²;
- gas flow between 0.1 sccm and 3 sccm, preferably lower than 1 sccm;
- working pressure between 2 × 10⁻³ mbar and 5 × 10⁻¹ mbar, preferably 10⁻³ mbar;
- deposition time between 0.3 min/g and 10 min/g, preferably lower than 5 min/g; and
- atomic concentration not greater than 0.15 at%, preferably lower than 0.1 at%.

It is a further object of the present invention that, for the cluster structure, the process parameters comprise:
- vacuum pressure preferably between 5 × 10⁻⁵ mbar and 5 × 10⁻⁶ mbar, preferably 5 × 10⁻⁶ mbar;
- plasma power density between 0.1 and 25 W/cm², preferably between 0.32 and 1.93 W/cm²;
- gas flow between 0.1 sccm and 3 sccm, preferably lower than 1 sccm;
- working pressure between 2 × 10⁻³ mbar and 5 × 10⁻¹ mbar, preferably 10⁻³ mbar;
- deposition time between 0.5 min/g and 15 min/g, preferably lower than 10 min/g; and
- atomic concentration up to 0.20 at%, preferably lower than 0.15 at%.
- vacuum pressure between 5 × 10⁻⁵ mbar and 5 × 10⁻⁶ mbar, preferably 5 × 10⁻⁶ mbar;

It is another object of the present invention that, for the sub-nanoparticle structure, the process parameters comprise:
- plasma power density between 0.1 and 25 W/cm², preferably between 0.32 and 1.93 W/cm²;
- gas flow between 1 sccm and 5 sccm, preferably lower than 2 sccm;
- working pressure between 2 × 10⁻³ mbar and 5 × 10⁻¹ mbar, preferably 10⁻³ mbar;
- deposition time between 0.5 min/g and 15 min/g, preferably lower than 10 min/g; and
- atomic concentration between 0.2 at% and 0.25 at%.

It is also an object of the invention that, for the nanoparticle structure, the process parameters comprise:
- vacuum pressure between 5 × 10⁻⁵ mbar and 5 × 10⁻⁶ mbar, preferably lower than 5 × 10⁻⁶ mbar;
- plasma power density between 0.1 and 25 W/cm², preferably between 0.32 and 1.93 W/cm²;
- gas flow between 1 sccm and 10 sccm, preferably lower than 5 sccm;
- working pressure between 2 × 10⁻³ mbar and 5 × 10⁻¹ mbar, preferably 10⁻³ mbar;
- deposition time between 5 min/g and 500 min/g, preferably lower than 30 min/g; and
- atomic concentration of up to 10 at%, preferably lower than 1 at%.

Another object of the invention alternatively comprises a process for forming cluster-type, sub-nanometric, or nanometric structures, with at least two target elements fused prior to deposition;

It is a further alternative object of the invention to provide a process with at least two independent target elements deposited simultaneously (concomitantly) onto the substrate material;

Another object of the present invention alternatively comprises at least two independent target elements deposited at different times (sequentially) onto the substrate material;

For the purposes of the present patent application, the term "single atom" refers to a single atom, the term "cluster" refers to a plurality of atoms, the term "MOFs" refers to metal-organic frameworks, the term "shutter system" refers to a shutter system, the term "physical vapor deposition" is referred to as PVD, and the term "data storage" refers to data storage.

### BRIEF DESCRIPTION OF THE DRAWINGS

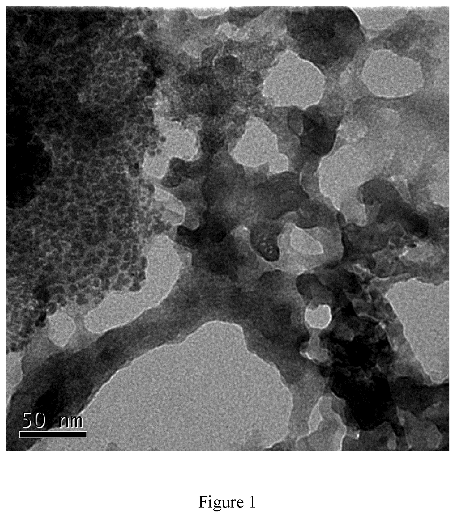

**FIGURE 1** illustrates a microscopy image of silver nanoparticles deposited on carbon black powder.

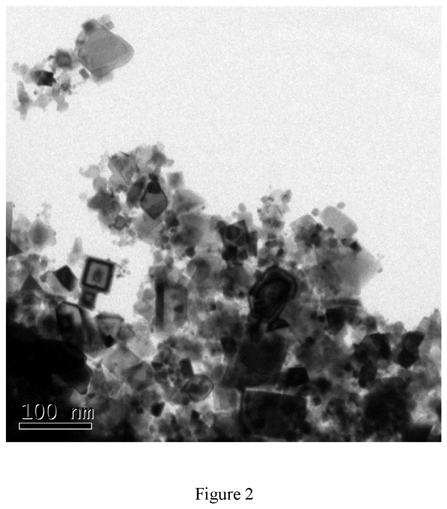

**FIGURE** 2 illustrates a microscopy image of palladium nanoparticles deposited on ceria powder (CeO₂).

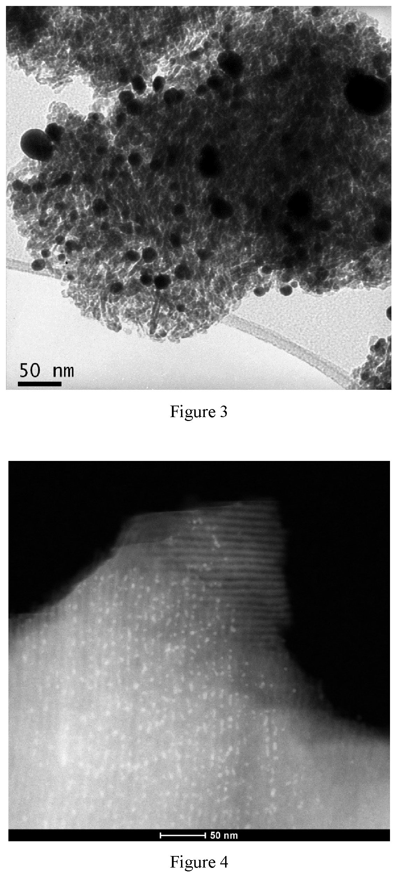

**FIGURE** 3 illustrates a microscopy image of palladium nanoparticles deposited on alumina powder (Al₂O₃).
**FIGURE 4** illustrates a microscopy image of palladium sub-nanoparticles deposited on silica powder (SiO₂) - SBA-15.

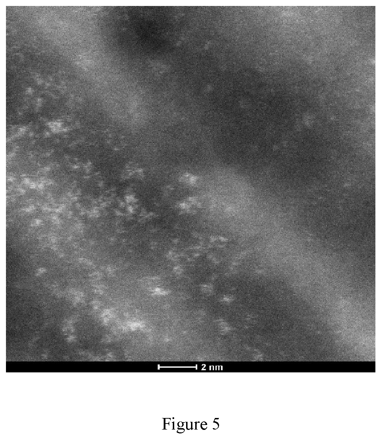

**FIGURE** 5 illustrates a microscopy image of palladium clusters deposited on silica (SiO₂) - SBA-15.
**FIGURE** 6 illustrates a mass calibration curve of silver, ruthenium, and niobium elements.
**FIGURE** 7(A) illustrates a single gun (2) with a single metallic alloy target being deposited and the formation of a coated substrate (3);
**FIGURE 7(B)** illustrates two guns (2) and (3), each having a different element, being deposited concomitantly onto the substrate (4); and

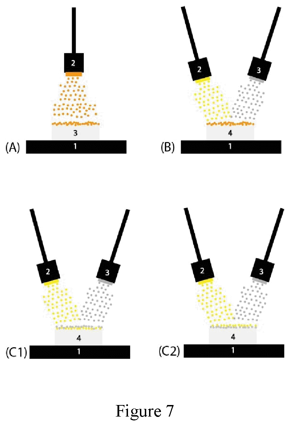

**FIGURE 7****(C1 and C2)** illustrate two guns (2) and (3), each having a different element, being deposited at different times (sequentially, one after the other).

### DETAILED DESCRIPTION OF THE INVENTION

The present invention relates to a physical process for enriching powder materials, which falls within the family of processes known as Physical Vapor Deposition (PVD).

In brief, PVD may be explained as the ejection of atoms or agglomerates of atoms from at least one target material (elements of the periodic table) and the subsequent deposition thereof onto a given base material (substrate). From a technical standpoint, the ejection of atoms from the target material may occur in different ways, including ejection by momentum transfer (sputtering), ejection by sublimation via heat (thermal deposition), ejection by sublimation via an electron beam (e-beam deposition), and laser-based ejection (laser ablation).

The present invention comprises the possibility that the substrate is a powder material (provided that it has a low vapor pressure, preferably on the order of 100 mbar). In this manner, the atoms ejected from the target material adhere to the powder particles, imparting new properties to such particles or forming new materials with predefined structures.

The physical enrichment technology has, as its main distinguishing feature, the precise control of deposition of the target material onto the powder particles within a vacuum environment, allowing different structures to be formed on their surface. Accordingly, atoms ejected from one or more targets of different compositions may achieve partial coverage, including single atoms, clusters, sub-nanometric particles, and dispersed nanoparticles.

The ultimate objective of the process is to optimize the characteristics of the substrate material that receives the atoms by adding properties that the material did not previously possess. For example, a plastic material that receives a gold coating acquires surface characteristics such as electrical conductivity, while maintaining the lightness and geometric form of the polymer in its original state. The possibility of predefining the structure to be created in the new material is fundamental for its future application. It is known that, in different applications, the type of structure of the supported material directly influences the final characteristics of the newly formed material.

The process described herein may be carried out using known PVD equipment capable of providing agitation of the substrate, preferably the equipment described in document BR102019008353.

Accordingly, the first step is the selection of the base material (powder substrate), which may belong to any class, such as polymeric, metallic, semiconductor, ceramic materials, molecular sieves, zeolites, perovskites, MOFs, carbon-based materials, or any other material having a vapor pressure lower than 100 mbar. After this step, the base material undergoes an optional treatment referred to as degassing, which comprises storing the substrate material in a pre-vacuum chamber evacuated to a pressure of 2 × 10⁻² mbar for a period that may range between 1 h and 8 h (typically at least 3 h). Degassing is carried out when the substrate material presents moisture.

Subsequently, a fraction of the stored base material is transferred to the main vacuum chamber, where it is positioned inside the chamber. The chamber is then evacuated to a base pressure with a maximum of 5 × 10⁻⁶ mbar.

The next step consists of selecting at least one element of the periodic table or combinations thereof as the target material. The element must be solid and have a vapor pressure lower than 100 mbar.

When the process is carried out with more than one target element, the target material may be deposited in at least three different ways, namely:
a) two or more elements fused together and added as a target in the same gun;
b) two or more individual elements inserted into different guns and deposited by a concomitant deposition process;
c) two or more individual elements inserted into different guns and deposited by a sequential deposition process.

Subsequently, the type of coating structure to be formed on the surface of the substrate material is defined, which may be single atom, cluster, sub-nanoparticle, or nanoparticle.

After selecting the structure, the values of the power density and deposition rate parameters are adjusted. These parameters are adjusted so as to comply with the maximum atomic concentration established for achieving each structure. The atomic concentration is determined by the relationship between the atomic density of the target material and the atomic density of the substrate material. The atomic concentration for each structure is defined according to **TABLE 1.**

**TABLE 1**

| Coating layer structure | Preferred atomic concentration (atomic density of the target element / atomic density of the substrate material) |
|---|---|
| *Single atom* | Lower than 0,1at% |
| *Cluster* | Lower than 0,15at% |
| Sub-nanometric | Between 0,2at% and 0,25at% |
| Nanometric | Lower than 1at% |

Accordingly, the power density and deposition rate parameters are defined through a trial-and-error approach, according to the steps described below:
a) Establishing an initial power density of the equipment, which may range between 0.1 and 25 W/cm²;
b) calibrating the deposition rate of the selected target material;
c) verifying whether the deposition rate is suitable to achieve the mass concentration of the planned structure; if not,
d) adjusting the power density until the deposition rate is sufficient to achieve the referenced mass concentration for each structure.

The next step is inserting the target materials into their respective guns of the equipment. Subsequently, a controlled flow of at least one gas (argon, nitrogen, oxygen, methane, or hydrogen) is introduced into the vacuum chamber. The flow control is performed by a commercial system known as a mass flow controller and ranges between 0.1 sccm and 10 sccm, depending on the type of structure to be formed.

The selection of the gases introduced into the chamber, as well as the flow proportion of each gas when more than one gas is introduced, is related to the material desired in the structure. This methodology is known in the art; however, by way of example, some cases are illustrated: for metallic structures, argon is used; for metal oxides, argon and oxygen are used; for metal nitrides, argon and nitrogen are used; for metal carbides, argon and methane with hydrogen are used; and for metal oxynitrides, argon, nitrogen, and oxygen are used. The methodology for selecting gases is known in the prior art and may be found in the following documents: FEIL, A. F.; COSTA, Marlla Vallerius da; KRELING, Afonso; JACOBSEN, Saulo Davila; VARGAS, André Luis Marin; FERNANDES, Jesum Alves; BLANDO, Eduardo; HÜBLER, Roberto. Influence of Deposition Parameters on the Corrosion Protection of TiN Deposited by Biased Magnetron Sputtering. Revista Brasileira de Aplicações de Vácuo, to be published, v. 25, p. 135-140, 2006; and Feil, Adriano F.; PAPLEO, R. M.; HÜBLER, R. Tuning the Crystalline Structure and Properties of TiO Thin Films Deposited by DC Reactive Magnetron Sputtering by Adjusting the Ar/O Ratio. Journal of Nanoscience and Nanotechnology, v. 17, p. 8967-8974, 2017.

Upon introducing the controlled gas flow into the vacuum chamber, partial closing of the valves of the vacuum system is carried out to obtain an equilibrium between the gas entering the chamber and the gas evacuated by the chamber vacuum system. For this purpose, the main valves are closed and a secondary vacuum circuit is activated, to which a fine throttling valve is adapted, capable of maintaining the chamber pressure between 5 × 10⁻³ mbar and 5 × 10⁻¹ mbar.

With the pressure stabilized, the power supply is activated and the plasma is stabilized at a power density between 0.1 W/cm² and 25 W/cm². After stabilization of the plasma, the shutter system is opened, initiating the deposition process of atoms from the target onto the powder material. The process is carried out for a period that may range between 0.3 min/g and 500 min/g, depending on the structure to be formed and/or the amount of material to be deposited. Thereafter, the process is finalized by switching off the power supply. The operation time must be sufficient such that the total atomic concentration remains low, preferably lower than 10% relative to the mass of the substrate material. Subsequently, the material is packaged in a container while still under vacuum.

To finalize the process of forming structures in the base material, the produced powder may be subjected to a thermal treatment (by placing the material in a furnace with or without a controlled atmosphere, at a temperature between 300 °C and 700 °C, depending on the composition of the material) to promote incorporation of the atoms (such as Au, Pt, Ir, Rh, Ni, and Co) into the base material. This subsequent thermal treatment step is not mandatory and may be carried out in situ or ex situ after the deposition process.

### PREFERRED EMBODIMENT

The single-atom structure was obtained using, as base materials, alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others. Initially, the selected material was stored in a pre-vacuum chamber and evacuated to a pressure of 2 × 10⁻² mbar for a period of at least 3 h. This step is carried out in order to remove moisture and oxygen from the surface of the silica.

In a second step, a fraction of the stored silica (1 g) was transferred to the main vacuum chamber and positioned in the agitation container inside the chamber.

For defining the single-atom structure, an initial power density of 0.32 W/cm² was established, after which calibration of the deposition rate of the target material was carried out on the equipment. It was verified that the deposition rate was suitable to achieve the atomic concentration of the planned structure.

Subsequently, the chamber was evacuated to a base pressure of 5 × 10⁻⁶ mbar. For this embodiment, processes were carried out using palladium metal.

Subsequently, a controlled flow of argon gas was introduced into the vacuum chamber. The flow was controlled by a commercial system known as a mass flow controller and was not greater than 1 sccm.

Upon introduction of the controlled argon flow into the vacuum chamber, partial closing of the valves of the vacuum system occurred in order to reach equilibrium between the gas entering the chamber and the gas evacuated from the chamber. For this purpose, the main valves were closed and a secondary vacuum circuit was activated, comprising a fine throttling valve capable of maintaining the chamber pressure at 5 × 10⁻³ mbar.

With the pressure stabilized, the power supply was turned on and the plasma was stabilized in a closed system at a power density not greater than 0.32 W/cm². After stabilization of the plasma, the shutter system was opened and the deposition process of target atoms onto the powder material under agitation was initiated.

The palladium deposition process was carried out for a period between 1.1 min/g and 11.2 min/g and was finalized by switching off the power supply.

It is essential that the process be interrupted within a short time so that the total atomic concentration is lower than 0.15 at% relative to the mass of the substrate material (SBA-15). Subsequently, the material was packaged in a container while still under vacuum.

To finalize the process of forming the single-atom structure, the produced powder was subjected to a thermal treatment to promote incorporation of Pd atoms into the crystalline lattice of the SBA-15 silica. This subsequent thermal treatment step is not mandatory and may be carried out in situ or ex situ after the deposition process.

At the end of the palladium deposition process onto the surface of the SBA-15 silica, high-resolution microscopy analyses and spectroscopic techniques were performed, indicating that atoms of the deposited metal were dispersed on the surface of the SBA-15.

These isolated atoms were preferentially trapped in oxygen vacancies or defect sites of the crystalline lattice of the silica.

With thermal treatment, these atoms may migrate within the structure, forming stronger chemical bonds with the silica.

The cluster-type structure was obtained using a base material (substrate) of alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others. Initially, the selected powder was stored in a pre-vacuum chamber and evacuated to a pressure of 2 × 10⁻² mbar for a period of at least 3 h. This step aims to remove moisture and oxygen from the surface of the alumina.

In a second step, a fraction of the stored alumina (1 g) was transferred to the main vacuum chamber and positioned in the agitation container inside the chamber.

For defining the cluster structure, a power density of 0.32 W/cm² was established, after which calibration of the deposition rate of the target material was carried out on the equipment. It was verified that the deposition rate was suitable to achieve the atomic concentration of the planned structure.

Subsequently, the chamber was evacuated to a base pressure of 5 × 10⁻⁶ mbar. Individual processes were carried out using palladium.

Subsequently, a controlled flow of argon gas was introduced into the vacuum chamber. The flow was controlled by a commercial system known as a mass flow controller and was not greater than 2 sccm.

Upon introduction of the controlled argon flow into the vacuum chamber, partial closing of the valves of the vacuum system occurred in order to achieve equilibrium between the gas entering the chamber and the gas evacuated from the chamber. For this purpose, the main valves were closed and a secondary vacuum circuit was activated, comprising a fine throttling valve capable of maintaining the chamber pressure at 5 × 10⁻³ mbar.

With the pressure stabilized, the power supply was switched on and the plasma was stabilized at a power density not greater than 0.6 W/cm². After stabilization of the plasma, the shutter system was opened and the deposition process of target atoms onto the powder material was initiated.

The process was carried out for a period between 2.3 min/g and 22.4 min/g and was finalized by switching off the power supply.

It is essential that the process be interrupted within a short time so that the total concentration of metallic atoms remains very low, lower than 0.20% relative to the mass of the substrate material. Subsequently, the material is packaged in a container while still under vacuum.

At the end of the Pd metal deposition process onto the surface of gamma alumina, high-resolution microscopy analyses and spectroscopic techniques were performed, indicating that clusters composed of agglomerates of 3 to 5 atoms were deposited in a dispersed manner on the surface of the alumina.

These clusters are formed because the metallic atoms (hot) thermalize and migrate over the surface of the alumina (which is at room temperature), forming clusters and/or agglomerates of atoms. The low metallic concentration deposited on the powder surface results in a final structure composed of only a few atoms.

The sub-nanoparticle structure was obtained using different powder substrates, such as alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others.

Initially, the selected powder (1 g) was stored in a pre-vacuum chamber, which was evacuated to a pressure of 2 × 10⁻² mbar under magnetic agitation for a period of at least 3 h. This step aims to remove moisture and oxygen from the surface of the powder.

In a second step, a fraction of the stored powder was transferred to the main vacuum chamber and positioned inside the chamber.

For defining the sub-nanoparticle structure, a power density of 0.60 W/cm² was established, after which calibration of the deposition rate of the target material was carried out on the equipment. It was verified that the deposition rate was suitable to achieve the atomic concentration of the planned structure.

Subsequently, the chamber was evacuated to a base pressure of at least 5 × 10⁻⁶ mbar. Individual processes were carried out using Pd metal.

Subsequently, a controlled flow of argon gas was introduced into the vacuum chamber. The flow was controlled by a commercial system known as a mass flow controller and was not greater than 5 sccm.

Upon introduction of the controlled argon flow into the vacuum chamber, partial closing of the valves of the vacuum system occurred in order to achieve equilibrium between the gas entering the chamber and the gas evacuated from the chamber. For this purpose, the main valves were closed and a secondary vacuum circuit was activated, comprising a fine throttling valve capable of maintaining the chamber pressure at exactly 5 × 10⁻³ mbar.

With the pressure stabilized, the power supply was switched on and the plasma was stabilized at a power density not greater than 1.26 W/cm². After stabilization of the plasma, the shutter system was opened and the deposition process of target atoms onto the powder material was initiated.

The process was carried out for a period between 3.4 min/g and 33.6 min/g, depending on the target material, and was finalized by switching off the power supply.

It is essential that the process be interrupted within a short time so that the total atomic concentration remains very low, lower than 0.30% relative to the mass of the substrate material. Subsequently, the material is packaged in a container while still under vacuum.

At the end of the deposition process of Pd metals onto the surface of alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others, high-resolution microscopy analyses and spectroscopic techniques were performed, showing the formation of sub-nanometric particles with an average diameter lower than 1 nm, deposited with high dispersion on the surface of the powder materials.

The nanoparticle-type structure was obtained using different powder substrates, such as alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others.

Initially, the selected powder was stored in a pre-vacuum chamber, which was evacuated to a pressure of 2 × 10⁻² mbar for a period of at least 3 h. This step aims to remove moisture and oxygen from the surface of the powder.

In a second step, a fraction of the stored powder was transferred to the main vacuum chamber and positioned in the agitation container inside the chamber.

For defining the nanoparticle structure, a power density of 1.26 W/cm² was established, after which calibration of the deposition rate of the target material was carried out on the equipment. It was verified that the deposition rate was suitable to achieve the atomic concentration of the planned structure.

Subsequently, the chamber was evacuated to a base pressure of at least 5 × 10⁻⁶ mbar. Individual processes were carried out using silver metal.

Subsequently, a controlled flow of argon gas was introduced into the vacuum chamber. The flow was controlled by a commercial system known as a mass flow controller and was not greater than 5 sccm.

Upon introduction of the controlled argon flow into the vacuum chamber, partial closing of the valves of the vacuum system occurred to obtain equilibrium between the gas entering the chamber and the gas evacuated from the chamber. For this purpose, the main valves were closed and a secondary vacuum circuit was activated, comprising a fine throttling valve capable of maintaining the chamber pressure at 5 × 10⁻³ mbar.

With the pressure stabilized, the power supply was switched on and the plasma was stabilized at a power density ranging between 1.26 and 5 W/cm².

After stabilization of the plasma, the shutter system was opened and the deposition process of target atoms onto the powder material under agitation was initiated.

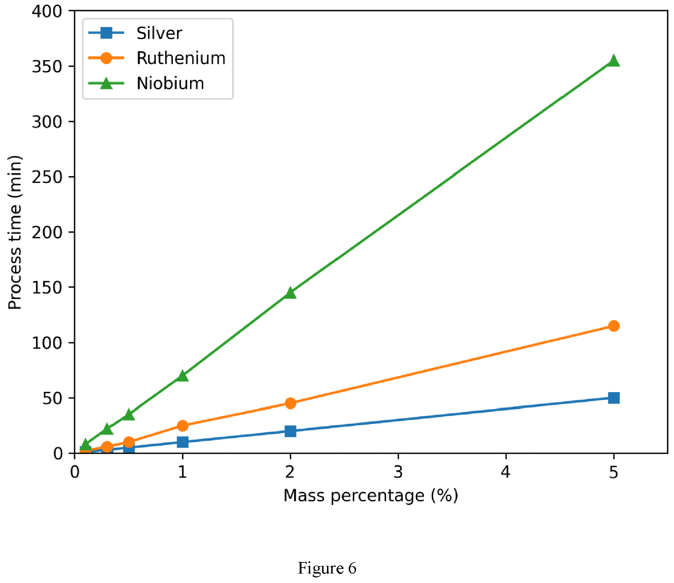

The process is carried out for a time proportional to the mass concentration of nanoparticles relative to the powder mass (FIGURE 6). The deposition time and the applied power are parameters that influence the size of the nanoparticles obtained. Typically, the higher the power used for a given deposition time, the larger the average nanoparticle size.

For the formation of homogeneous and well-dispersed nanoparticles, the maximum atomic concentration should be between 0.4 and 10%. At the end of the process, the material is packaged in a container while still under vacuum.

At the end of the silver deposition process onto the surface of alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others, high-resolution microscopy analyses and spectroscopic techniques were performed. The tests carried out demonstrated the formation of nanometric particles having an average diameter ranging between 1 and 50 nm, as a function of the deposition time and/or the applied power.

The analyzed samples showed that the nanoparticles exhibit high dispersion on the surface of the powder materials and that there is precise control of the average diameter with low dispersion. It was observed that the lower the deposition power density (lower than 1.26 W/cm²), the lower the powder sample temperature and the lower the metal concentration, the smaller the diameter of the nanoparticles formed.

Formation of TiO₂ nanoparticles from a metallic titanium target. The TiO₂ nanoparticle-type structure was obtained using different powder substrates, such as alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others.

Initially, the selected powder was stored in a pre-vacuum chamber, which was evacuated to a pressure of 2 × 10⁻² mbar for a period of at least 3 h. This step aims to remove moisture and oxygen from the surface of the powder.

In a second step, a fraction of the stored powder (1 g) was transferred to the main vacuum chamber and positioned in the agitation container inside the chamber.

For defining the nanoparticle structure, a power density of 1.26 W/cm² was established, after which calibration of the deposition rate of the target material was carried out on the equipment. It was verified that the deposition rate was suitable to achieve the atomic concentration of the planned structure.

Subsequently, the chamber was evacuated to a base pressure of at least 5 × 10⁻⁶ mbar. A titanium target was selected.

Subsequently, a controlled flow of argon and oxygen gases at a ratio of 5:1 was introduced into the vacuum chamber. The flow was controlled by a commercial system known as a mass flow controller and was not greater than 5 sccm.

Upon introduction of the controlled argon and oxygen flow into the vacuum chamber, partial closing of the valves of the vacuum system occurred in order to achieve equilibrium between the gas entering the chamber and the gas evacuated from the chamber. For this purpose, the main valves were closed and a secondary vacuum circuit was activated, comprising a fine throttling valve capable of maintaining the chamber pressure at exactly 5 × 10⁻³ mbar.

With the pressure stabilized, the power supplies were switched on and the plasma was stabilized at a power density not greater than 1.93 W/cm². After stabilization of the plasma, the shutter was opened and the deposition process of atoms from the targets onto the powder material under agitation was initiated.

The process was carried out for a period of 8 min and was finalized by switching off the power supply.

Formation of TiO₂ nanoparticles using a TiO₂ target.

The TiO₂ nanoparticle-type structure was obtained using different powder substrates, such as alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others.

Initially, the selected powder was stored in a pre-vacuum chamber, which was evacuated to a pressure of 2 × 10⁻² mbar for a period of at least 3 h. This step aims to remove moisture and oxygen from the surface of the powder.

In a second step, a fraction of the stored powder was transferred to the main vacuum chamber and positioned in the agitation container inside the chamber.

For defining the nanoparticle structure, a power density of 1.26 W/cm² was established, after which calibration of the deposition rate of the target material was carried out on the equipment. It was verified that the deposition rate was suitable to achieve the atomic concentration of the planned structure.

Subsequently, the chamber was evacuated to a base pressure of at least 5 × 10⁻⁶ mbar. A titanium oxide (TiO₂) target was selected.

Subsequently, a controlled flow of argon gas was introduced into the vacuum chamber. The flow was controlled by a commercial system known as a mass flow controller and was not greater than 5 sccm.

Upon introduction of the controlled argon flow into the vacuum chamber, partial closing of the valves of the vacuum system occurred in order to achieve equilibrium between the gas entering the chamber and the gas evacuated from the chamber. For this purpose, the main valves were closed and a secondary vacuum circuit was activated, comprising a fine throttling valve capable of maintaining the chamber pressure at exactly 5 × 10⁻³ mbar.

With the pressure stabilized, the power supplies were switched on and the plasma was stabilized at a power density not greater than 1.93 W/cm². After stabilization of the plasma, the shutter was opened and the deposition process of atoms from the targets onto the powder material under agitation was initiated.

The process was carried out for a period of 8 min and was finalized by switching off the power supply.

Formation of TiN nanoparticles from a metallic titanium target.

The TiN nanoparticle-type structure was obtained using different powder substrates, such as alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others.

Initially, the selected powder was stored in a pre-vacuum chamber, which was evacuated to a pressure of 2 × 10⁻² mbar for a period of at least 3 h. This step aims to remove moisture and oxygen from the surface of the powder.

In a second step, a fraction of the stored powder was transferred to the main vacuum chamber.

For defining the nanoparticle structure, a power density of 1.26 W/cm² was established, after which calibration of the deposition rate of the target material was carried out on the equipment. It was verified that the deposition rate was suitable to achieve the atomic concentration of the planned structure.

Subsequently, the chamber was evacuated to a base pressure of at least 5 × 10⁻⁶ mbar. A titanium target was selected.

Subsequently, a controlled flow of argon and nitrogen gases at a ratio of 3:1 was introduced into the vacuum chamber. The flow was controlled by a commercial system known as a mass flow controller and was not greater than 5 sccm.

Upon introduction of the controlled argon and nitrogen flow into the vacuum chamber, partial closing of the valves of the vacuum system occurred in order to achieve equilibrium between the gas entering the chamber and the gas evacuated from the chamber. For this purpose, the main valves were closed and a secondary vacuum circuit was activated, comprising a fine throttling valve capable of maintaining the chamber pressure at exactly 5 × 10⁻³ mbar.

With the pressure stabilized, the power supplies were switched on and the plasma was stabilized at a power density not greater than 1.93 W/cm². After stabilization of the plasma, the shutter was opened and the deposition process of atoms from the targets onto the powder material was initiated.

The process was carried out for a period of 8 min and was finalized by switching off the power supply.

Formation of bimetallic AuAg sub-nanoparticles using an AuAg target.

The bimetallic sub-nanoparticle-type structure was obtained using different powder substrates, such as alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others.

Initially, the selected powder was stored in a pre-vacuum chamber, which was evacuated to a pressure of 2 × 10⁻² mbar for a period of at least 3 h. This step aims to remove moisture and oxygen from the surface of the powder.

In a second step, a fraction of the stored powder was transferred to the main vacuum chamber and positioned inside the chamber.

For defining the sub-nanoparticle structure, a power density of 0.6 W/cm² was established, after which calibration of the deposition rate of the target material was carried out on the equipment. It was verified that the deposition rate was suitable to achieve the atomic concentration of the planned structure.

Subsequently, the chamber was evacuated to a base pressure of at least 5 × 10⁻⁶ mbar. A metallic alloy Au-Ag target was selected.

Subsequently, a controlled flow of argon gas was introduced into the vacuum chamber. The flow was controlled by a commercial system known as a mass flow controller and was not greater than 5 sccm.

Upon introduction of the controlled argon flow into the vacuum chamber, partial closing of the valves of the vacuum system occurred in order to achieve equilibrium between the gas entering the chamber and the gas evacuated from the chamber. For this purpose, the main valves were closed and a secondary vacuum circuit was activated, comprising a fine throttling valve capable of maintaining the chamber pressure at exactly 5 × 10⁻³ mbar.

With the pressure stabilized, the power supply was switched on and the plasma was stabilized at a power density not greater than 0.32 W/cm². After stabilization of the plasma, the shutter was opened and the deposition process of atoms from the targets onto the powder material was initiated.

The process was carried out for a period of 8 min and was finalized by switching off the power supply.

The bimetallic sub-nanoparticle-type structure was obtained using different powder substrates, such as alumina (Al₂O₃), ceria (Ce₂O₃), zirconia (ZrO₂), titania (TiO₂), silica (SiO₂), sodium titanate nanotubes, graphene, carbon black, carbon nanotubes (CNT), PTFE, PEEK, among others.

Initially, the selected powder was stored in a pre-vacuum chamber, which was evacuated to a pressure of 2 × 10⁻² mbar for a period of at least 3 h. This step aims to remove moisture and oxygen from the surface of the powder.

In a second step, a fraction of the stored powder was transferred to the main vacuum chamber and positioned inside the chamber.

For defining the sub-nanoparticle structure, a power density of 0.6 W/cm² was established for silver and 0.32 W/cm² for gold. Subsequently, calibration of the deposition rate of the target material was carried out on the equipment. It was verified that the deposition rate was suitable to achieve the atomic concentration of the planned structure.

Subsequently, the chamber was evacuated to a base pressure of at least 5 × 10⁻⁶ mbar. Silver and gold targets were selected.

Subsequently, a controlled flow of argon gas was introduced into the vacuum chamber. The flow was controlled by a commercial system known as a mass flow controller and was not greater than 5 sccm.

Upon introduction of the controlled argon flow into the vacuum chamber, partial closing of the valves of the vacuum system occurred in order to achieve equilibrium between the gas entering the chamber and the gas evacuated from the chamber. For this purpose, the main valves were closed and a secondary vacuum circuit was activated, comprising a fine throttling valve capable of maintaining the chamber pressure at exactly 5 × 10⁻³ mbar.

With the pressure stabilized, the power supplies were switched on and the plasma was stabilized at a power density not greater than 0.6 W/cm² for silver and 0.32 W/cm² for gold. After stabilization of the plasma, the shutters were opened and the deposition process of atoms from the targets onto the powder material was initiated.

The process was carried out for a period of 8 min and was finalized by switching off the power supply.

The TABLE 2 describes, by way of example, certain elements and the data of each parameter required to achieve the desired structure on the surface of the substrate.

**TABLE 2**

| **Element** | **Power density (W/cm2)** | **Deposition rate (A/s)** | **Time for formation of the desired structure (min)** | | | |
|---|---|---|---|---|---|---|
| | | | *Single atom* | *clusters* | *Sub-nano* | *nanoparticles* |
| Copper | 0,32 | 10 | 9 | 18 | 28 | 46 |
| Copper | 0,60 | 18 | 5 | 10 | 15,5 | 26 |
| Copper | 1,26 | 36 | 2,5 | 5 | 7,7 | 12,8 |
| Copper | 1,93 | 54 | 1,7 | 3,4 | 5,1 | 8,6 |
| Palladium | 0,32 | 0,6 | 11,2 | 22,4 | 33,6 | 56 |
| Palladium | 0,60 | 1,5 | 4,4 | 8,8 | 13,2 | 22 |
| Palladium | 1,26 | 3,8 | 1,8 | 3,6 | 5,4 | 9,1 |
| Palladium | 1,93 | 6,0 | 1,1 | 2,3 | 3,4 | 5,7 |
| Gold | 0,32 | 1,1 | 3,9 | 7,7 | 11,6 | 19,3 |
| Gold | 0,60 | 2,0 | 2,1 | 4,2 | 6,4 | 10,6 |
| Gold | 1,26 | 4,1 | 1 | 2 | 3,1 | 5,2 |
| Gold | 1,93 | 6,3 | 0,7 | 1,4 | 2 | 3,4 |
| Silver | 0,32 | 0,5 | 15 | 30 | 44,9 | 74,8 |
| Silver | 0,60 | 1,8 | 4,4 | 8,9 | 13,3 | 22,2 |
| Silver | 1,26 | 4,7 | 1,7 | 3,3 | 5 | 8,4 |
| Silver | 1,93 | 7,7 | 1 | 2 | 3 | 5,1 |
| Lead | 0,32 | 2,0 | 3,6 | 7,1 | 10,7 | 17,8 |
| Lead | 0,60 | 4,3 | 1,7 | 3,4 | 5 | 8,4 |
| Lead | 1,26 | 9,6 | 0,8 | 1,5 | 2,3 | 3,8 |
| Lead | 1,93 | 15 | 0,5 | 1 | 1,5 | 2,4 |

## Claims

1. Manufacturing process for powder materials by controlled spraying of atoms of a target material and subsequently depositing them onto a powder base material, **CHARACTERIZED BY** comprising the steps of:
a) **selecting** a powder substrate material having a vapor pressure lower than 100 mbar;
b) **optionally performing** a degassing step of the substrate material;
d) **evacuating** the chamber to the lowest possible vacuum pressure, preferably to 5 × 10⁻⁶ mbar;
e) **selecting** at least one element of the periodic table having a vapor pressure lower than 100 mbar as a target material;
f) **defining** the type of coating structure to be formed on the surface of the substrate material, which may be a single atom, a cluster, a sub-nanoparticle, or a nanoparticle;
g) **defining** the values of the power density and deposition rate parameters;
h) **placing** the target materials into the sputtering guns;
i) **initiating** a controlled flow of at least one gas into the vacuum chamber, between 0.1 sccm and 10 sccm;
j) **maintaining** the working pressure between 5 × 10⁻³ mbar and 10⁻¹ mbar;
k) **activating** the power supply and stabilizing the plasma at a power density between 0.1 W/cm² and 25 W/cm²;
l) **initiating** the deposition process of atoms of the target material onto the surface of the substrate material;
m) **maintaining** the deposition for a period between 0.3 min/g and 500 min/g to deposit atoms of the target material onto the surface of the substrate material;
n) **maintaining** the atomic concentration below 10 at%;
o) **switching off** the power supply; and
p) **packaging** the coated substrate material.

2. Manufacturing process for powder materials according to claim 1, **CHARACTERIZED IN THAT** the selected substrate material is preferably a polymeric, metallic, semiconductor, ceramic, molecular sieve, perovskite, MOF (metal-organic framework), or carbonaceous material.

3. Manufacturing process for powder materials according to claim 1, **CHARACTERIZED IN THAT** the target material preferably has a vapor pressure of 10⁻¹ mbar.

4. Manufacturing process for powder materials according to claim 1, **CHARACTERIZED IN THAT** the target material is introduced into the equipment in the form of an alloy or as a pure element.

5. Manufacturing process for powder materials according to claim 1, **CHARACTERIZED IN THAT** the process for forming cluster-type, sub-nanometric, or nanometric structures comprises at least two target elements fused together.

6. Manufacturing process for powder materials according to claim 1, **CHARACTERIZED IN THAT** the process for forming cluster-type, sub-nanometric, or nanometric structures comprises at least two target elements individually placed in respective guns and deposited onto the substrate material concomitantly.

7. Manufacturing process for powder materials according to claim 1, **CHARACTERIZED IN THAT** the process for forming cluster-type, sub-nanometric, or nanometric structures comprises at least two target elements individually placed in respective guns and deposited onto the substrate material at different times, sequentially.

8. Manufacturing process for powder materials according to claim 1, **CHARACTERIZED IN THAT** the degassing step is carried out when the substrate material presents moisture.

9. Manufacturing process for powder materials according to claim 1, **CHARACTERIZED IN THAT** the degassing of the substrate material comprises the steps of:
a) **placing** the substrate material in a pre-vacuum chamber;
b) **evacuating** the chamber until a pressure of 2 × 10⁻² mbar is reached; and
c) **maintaining** the substrate material in the pre-vacuum chamber for a period between 1 h and 8 h.

10. Manufacturing process for powder materials according to claims 1 and 3, **CHARACTERIZED IN THAT** the degassing period of the substrate material is preferably 3 h.

11. Manufacturing process for powder materials according to claim 1, **CHARACTERIZED IN THAT** defining the coating structure on the surface of the substrate comprises the steps of:
a) **establishing** an initial power density of the equipment between 0.1 and 25 W/cm²;
b) **calibrating** the deposition rate of the target material;
c) **verifying** whether the deposition rate of the target material is suitable to achieve the atomic concentration of the planned structure; and, if not,
d) **adjusting** the power density until the deposition rate is sufficient to achieve the atomic concentration for each structure.

12. Manufacturing process for powder materials according to claim 1, **CHARACTERIZED IN THAT** the gases introduced into the vacuum chamber preferably comprise argon, nitrogen, oxygen, methane, or hydrogen.

13. Manufacturing process for powder materials according to claim 1, **CHARACTERIZED IN THAT,** alternatively, at the end of the process, a thermal treatment is carried out on the coated substrate material.

14. Manufacturing process for powder materials according to claim 1, **CHARACTERIZED IN THAT** gas control is carried out by a mass flow controller system.

15. Manufacturing process for powder materials according to claim 1, **CHARACTERIZED IN THAT** for a single-atom structure the process parameters preferably comprise:
a) a vacuum pressure of 5 × 10⁻⁶ mbar;
b) a plasma power density between 0.32 and 1.93 W/cm²;
c) a gas flow lower than 1 sccm;
d) a working pressure of 10⁻³ mbar;
e) a deposition time shorter than 5 min/g; and
f) an atomic concentration lower than 0.1 at%.

16. Manufacturing process for powder materials according to claims 1 and 10, **CHARACTERIZED IN THAT** for a **cluster structure** the process parameters preferably comprise:
a) a vacuum pressure of 5 × 10⁻⁶ mbar;
b) a power density between 0.32 and 1.93 W/cm²;
c) a gas flow lower than 1 sccm;
d) a working pressure of 10⁻³ mbar;
e) a deposition time shorter than 10 min/g; and
f) an atomic concentration up to 0.20 at%.

17. Manufacturing process for powder materials according to claims 1 and 10, **CHARACTERIZED IN THAT** for a **sub-nanoparticle structure** the process parameters preferably comprise:
a) a vacuum pressure of 5 × 10⁻⁶ mbar;
b) a plasma power density between 0.32 and 1.93 W/cm²;
c) a gas flow lower than 2 sccm;
d) a working pressure of 10⁻³ mbar;
e) a deposition time shorter than 10 min/g; and
f) an atomic concentration between 0.2 at% and 0.25 at%.

18. Manufacturing process for powder materials according to claims 1 and 10, **CHARACTERIZED IN THAT** for a **nanoparticle structure** the process parameters preferably comprise:
a) a vacuum pressure lower than 5 × 10⁻⁶ mbar;
b) a power density between 0.32 and 1.93 W/cm²;
c) a gas flow lower than 5 sccm;
d) a working pressure of 10⁻³ mbar;
e) a deposition time shorter than 30 min/g; and
f) an atomic concentration lower than 1 at%.
